# EUROPEAN PATENT APPLICATION

(11) **EP 4 560 636 A1**
(43) Date of publication of application: **28.05.2025**
(21) Application number: 23854003.3
(22) Date of filing: 29.05.2023
(51) Int. Cl.: G11C 11/22

(54) **FERROELECTRIC MEMORY AND TERMINAL**

(30) Priority: 17.08.2022 CN 202210987381
(71) Applicant: Huawei Technologies Co., Ltd., Shenzhen, Guangdong 518129 (CN)
(72) Inventor: LI, Hao, Shenzhen, Guangdong 518129 (CN); JIA, Xiufeng, Shenzhen, Guangdong 518129 (CN); ZHANG, Min, Shenzhen, Guangdong 518129 (CN); ZHAO, Jie, Shenzhen, Guangdong 518129 (CN); ZHANG, Heng, Shenzhen, Guangdong 518129 (CN); YANG, Xichao, Shenzhen, Guangdong 518129 (CN); LV, Hangbing, Shenzhen, Guangdong 518129 (CN); XU, Jeffrey Junhao, Shenzhen, Guangdong 518129 (CN)
(74) Representative: MERH-IP Matias Erny Reichl Hoffmann Patentanwälte PartG mbB
(86) International application number: PCT/CN2023/096767
(87) International publication number: WO 2024/037097

(57) **Abstract**

This application provides a ferroelectric random access memory and a terminal, and relates to the field of storage technologies, to improve strength of a read signal and read efficiency in a read phase, and reduce an area of the ferroelectric random access memory. The ferroelectric random access memory includes bit lines, an ith plate line, a multiplexer, a sense amplifier, and a plurality of ferroelectric memory cells. Each ferroelectric memory array of the plurality of ferroelectric memory cells includes m columns of ferroelectric memory cells arranged in array, and the ferroelectric memory cell includes one ferroelectric capacitor and one first transistor. In any row, a ferroelectric capacitor of the (m*n+i)^{th} column of ferroelectric memory cells is electrically connected to the ith plate line; and in the read phase, each plate line in the ith plate line inputs a high level to the ferroelectric memory cell in a time division manner, where m is an integer greater than or equal to 2, n is an integer greater than or equal to 0, and i is a positive integer less than or equal to m. Each column of ferroelectric memory cells are electrically connected to one of the bit lines, and every m bit lines are electrically connected to a same multiplexer. Each sense amplifier is electrically connected to one multiplexer.

## Description

This application claims priority to Chinese Patent Application No. 202210987381.1, filed with the China National Intellectual Property Administration on August 17, 2022, and entitled "FERROELECTRIC RANDOM ACCESS MEMORY AND TERMINAL", which is incorporated herein by reference in its entirety.

### TECHNICAL FIELD

This application relates to the field of storage technologies, and in particular, to a ferroelectric random access memory and a terminal.

### BACKGROUND

A ferroelectric random access memory is a new type of non-volatile memory technology, and has a potential to replace a related storage device in a current market because of advantages of the ferroelectric random access memory, such as high-speed read/write, high-density storage, low power consumption, and radiation resistance.

The ferroelectric random access memory includes a plurality of ferroelectric memory cells. After passing through a multiplexer, signals read from the plurality of ferroelectric memory cells may be input to a sense amplifier, to identify, through the sense amplifier, that the read signals are "1" or "0".

However, all of the plurality of ferroelectric memory cells are electrically connected to the same multiplexer, and the plurality of ferroelectric memory cells read the signals simultaneously. Therefore, a part of ferroelectric memory cells may be far away from the multiplexer, resulting in an excessively great length of a bit line used to transmit a read signal, and affecting strength of the read signal. As a result signals read by adjacent ferroelectric memory cells are coupled to each other, affecting an identification result. In addition, the signals read from the plurality of ferroelectric memory cells are sequentially input to the multiplexer, and the multiplexer and the sense amplifier need to repeat a plurality of times to complete reading of the signals from the plurality of ferroelectric memory cells, resulting in a slow reading speed and a weaker signal that is read later.

### SUMMARY

This application provides a ferroelectric random access memory and a terminal, to improve strength of a read signal and read efficiency in a read phase, and reduce a layout area occupied by the ferroelectric random access memory.

According to a first aspect, this application provides a ferroelectric random access memory. The ferroelectric random access memory includes a plurality of bit lines, an ith plate line, a multiplexer, a sense amplifier, and a plurality of ferroelectric memory cells. The plurality of ferroelectric memory cells are grouped into at least one ferroelectric memory array, each ferroelectric memory array includes m columns of ferroelectric memory cells arranged in array, and the ferroelectric memory cell includes one ferroelectric capacitor and one first transistor. In any row of the ferroelectric memory array, a ferroelectric capacitor of the (m*n+i)^{th} column of ferroelectric memory cells is electrically connected to the ith plate line; and in a read phase, each plate line in the ith plate line inputs a high level to the ferroelectric memory cell in a time division manner, where m is an integer greater than or equal to 2, n is an integer greater than or equal to 0, and i is a positive integer less than or equal to m. In the plurality of ferroelectric memory cells, first transistors of each column of ferroelectric memory cells are electrically connected to one of the bit lines, and m bit lines electrically connected to one ferroelectric memory array are electrically connected to a same multiplexer. One input end of each sense amplifier is electrically connected to an output end of one multiplexer, and another input end of the sense amplifier is configured to receive a reference voltage.

For example, m=2. In any row, a ferroelectric capacitor of an odd column of ferroelectric memory cells is electrically connected to a first plate line in the ith plate line, and a ferroelectric capacitor of an even column of ferroelectric memory cells is electrically connected to a second plate line in the ith plate line; and two bit lines electrically connected to every two adjacent columns of ferroelectric memory cells are electrically connected to a same multiplexer.

Based on a size of the sense amplifier, two consecutive adjacent columns of ferroelectric memory cells may be disposed opposite to the sense amplifier. In this way, a bit line electrically connected to a part of ferroelectric memory cells can be electrically connected to the sense amplifier without a need to extend in a row direction, to avoid a case in which a capacitance value of a bit line capacitance is greatly increased due to lengthening of the bit line, and strength of a read signal is affected.

Although two adjacent columns of ferroelectric memory cells in a ferroelectric memory array may send read signals to a same multiplexer, because the two adjacent columns of ferroelectric memory cells in the ferroelectric memory array read the read signals in a time division manner, there is no case in which a plurality of ferroelectric memory cells simultaneously send read signals to a same multiplexer through a plurality of bit lines, and the plurality of bit lines do not need to sequentially transmit the read signals to the multiplexer. This can avoid a case in which the read signals finally received by the sense amplifier becomes weak due to losses of the read signals in a process of waiting to be transmitted to the multiplexer, and can further shorten total time of the read phase, to improve read efficiency.

In addition, there is always an even column of ferroelectric memory cells spaced between every two adjacent odd columns of ferroelectric memory cells; and there is always an odd column of ferroelectric memory cells spaced between every two adjacent even columns of ferroelectric memory cells. Therefore, a problem of mutual coupling between the signals on the bit lines that are electrically connected to the two adjacent columns of ferroelectric memory cells in the read phase can be avoided, and strength of the read signals is not affected. On this basis, in a phase of reading the odd column, a low level may be further provided for the bit line electrically connected to the even column of ferroelectric memory cells, so that the bit line electrically connected to the even column of ferroelectric memory cells is in a shielded state, to shield coupling between both sides of the odd column and the bit line electrically connected to the odd column of ferroelectric memory cells, so as to further resolve the foregoing coupling problem. Similarly, in a phase of reading the even column, a low level may be further provided for the bit line electrically connected to the odd column of ferroelectric memory cells.

In addition, because the problem of mutual coupling between the signals on the bit lines that are electrically connected to the two adjacent columns of ferroelectric memory cells in the read phase is resolved, there is no need to use a large-area ferroelectric capacitor to reduce read signal interference caused by coupling, so that a layout area of the ferroelectric capacitor and even a layout area of the ferroelectric random access memory can be reduced.

For another example, m=4. In any row, a ferroelectric capacitor of the (m*n+1)^{th} column of ferroelectric memory cells is electrically connected to a first plate line in the ith plate line, a ferroelectric capacitor of the (m*n+2)^{th} column of ferroelectric memory cells is electrically connected to a second plate line in the ith plate line, a ferroelectric capacitor of the (m*n+3)^{th} column of ferroelectric memory cells is electrically connected to a third plate line in the ith plate line, and a ferroelectric capacitor of the (m*n+4)^{th} column of ferroelectric memory cells is electrically connected to a fourth plate line in the ith plate line; and four bit lines electrically connected to every four adjacent columns of ferroelectric memory cells are electrically connected to a same multiplexer.

Based on a size of the sense amplifier, four consecutive adjacent columns of ferroelectric memory cells may be disposed opposite to the sense amplifier. In this way, a bit line electrically connected to a part of ferroelectric memory cells can be electrically connected to the sense amplifier without a need to extend in a row direction, to avoid a case in which a capacitance value of a bit line capacitance is greatly increased due to lengthening of the bit line, and strength of a read signal is affected.

Although four adjacent columns of ferroelectric memory cells in a ferroelectric memory array may send read signals to a same multiplexer, because the four adjacent columns of ferroelectric memory cells in the ferroelectric memory array read the read signals in a time division manner, there is no case in which a plurality of ferroelectric memory cells simultaneously send read signals to a same multiplexer through a plurality of bit lines, and the plurality of bit lines do not need to sequentially transmit the read signals to the multiplexer. This can avoid a case in which the read signals finally received by the sense amplifier becomes weak due to losses of the read signals in a process of waiting to be transmitted to the multiplexer, and can further shorten total time of the read phase, to improve read efficiency.

In addition, there are further three columns of ferroelectric memory cells spaced between every two columns of ferroelectric memory cells whose read signals are simultaneously read. Therefore, a problem of mutual coupling between the signals on the bit lines that are electrically connected to the two adjacent columns of ferroelectric memory cells in the read phase can be avoided, and strength of the read signals is not affected. On this basis, in a phase of reading the (m*n+1)^{th} column, a low level may be further provided for bit lines electrically connected to the (m*n+2)^{th} column, the (m*n+3)^{th} column, and the (m*n+4)^{th} column of ferroelectric memory cells, so that the bit lines electrically connected to the (m*n+2)^{th} column, the (m*n+3)^{th} column, and the (m*n+4)^{th} column of ferroelectric memory cells are in a shielded state, to shield coupling between both sides of the (m*n+1)^{th} column and the bit line electrically connected to the (m*n+1)^{th} column of ferroelectric memory cells, so as to further resolve the foregoing coupling problem. Similarly, in a phase of reading the (m*n+2)^{th} column, or the (m*n+3)^{th} column, or the (m*n+4)^{th} column, the low level may be further provided for a bit line electrically connected to another column of ferroelectric memory cells.

In addition, because the problem of mutual coupling between the signals on the bit lines that are electrically connected to the two adjacent columns of ferroelectric memory cells in the read phase is resolved, there is no need to use a large-area ferroelectric capacitor to reduce read signal interference caused by coupling, so that a layout area of the ferroelectric capacitor and even a layout area of the ferroelectric random access memory can be reduced.

In some possible implementations, the ferroelectric random access memory further includes a plurality of word lines; and in the plurality of ferroelectric memory cells, gates of first transistors in one row of ferroelectric memory cells are electrically connected to a same word line in a row direction. In this way, a first transistor of the i^{th} column of ferroelectric memory cells and the second transistor electrically connected to the ith plate line may be simultaneously turned on, and no additional conducting wire that drives the second transistor to be turned on is needed.

In some possible implementations, the ferroelectric random access memory further includes an ith plate line selector; and the ith plate line selector is electrically connected to the ith plate line, and is configured to send the high level to the ith plate line in the read phase.

Specifically, the ith plate line selector includes a second transistor, and both the first transistor and the second transistor are N-type transistors or P-type transistors; a gate of the second transistor in the ith plate line selector is electrically connected to the word line electrically connected to the ith plate line; and when a read signal of the (m*n+i)^{th} column of ferroelectric memory cells is read, a source of the second transistor in the ith plate line selector inputs the high level to the ith plate line, and a voltage received by a source of another second transistor is 0 V. Therefore, in a phase of reading the (m*n+i)^{th} column of ferroelectric memory cells, only the second transistor of the ith plate line selector inputs the high level to the (m*n+i)^{th} column of ferroelectric memory cells through the ith plate line, to read the read signal.

For example, in a phase of reading the (m*n+1)^{th} column of ferroelectric memory cells, only a second transistor of a first plate line selector inputs the high level to the (m*n+1)^{th} column of ferroelectric memory cells 10 through the first plate line PL 1, to read the read signal. A second transistor of another plate line selector inputs 0 V to a ferroelectric memory cell other than the (m*n+1)^{th} column of ferroelectric memory cells through another plate line. In this way, the ferroelectric memory cell other than the (m*n+1)^{th} column of ferroelectric memory cells has no signal to be read presently.

According to a second aspect, this application provides a ferroelectric random access memory. The ferroelectric random access memory includes a plurality of bit lines, an ith plate line, a first multiplexer, a second multiplexer, a sense amplifier, and a plurality of ferroelectric memory cells, where the plurality of ferroelectric memory cells are grouped into at least one ferroelectric memory array, each ferroelectric memory array includes m columns of ferroelectric memory cells arranged in array, the ferroelectric memory cell includes a first ferroelectric memory cell and a second ferroelectric memory cell, and each of the first ferroelectric memory cell and the second ferroelectric memory cell includes one ferroelectric capacitor and one first transistor;
in any row of the ferroelectric memory array, a ferroelectric capacitor of the (m*n+i)^{th} column of ferroelectric memory cells is electrically connected to the ith plate line; and in a read phase, each plate line in the ith plate line inputs a high level to the ferroelectric memory cell in a time division manner, where m is an integer greater than or equal to 2, n is an integer greater than or equal to 0, and i is a positive integer less than or equal to m; and
in the plurality of ferroelectric memory cells, each column of first ferroelectric memory cell are electrically connected to one of the bit lines and each column of second ferroelectric memory cell are electrically connected to one of the bit lines, m bit lines electrically connected to every m adjacent columns of first ferroelectric memory cells are electrically connected to the first multiplexer, m bit lines electrically connected to every m adjacent columns of second ferroelectric memory cells are electrically connected to the second multiplexer, and output ends of the first multiplexer and the second multiplexer that are electrically connected to the first ferroelectric memory cell and the second ferroelectric memory cell of the same ferroelectric memory cell are electrically connected to input ends of the same sense amplifier.

For example, m=2. In any row, a ferroelectric capacitor of an odd column of ferroelectric memory cells is electrically connected to a first plate line in the ith plate line, and a ferroelectric capacitor of an even column of ferroelectric memory cells is electrically connected to a second plate line in the ith plate line; and two bit lines electrically connected to every two adjacent columns of first ferroelectric memory cells are electrically connected to the first multiplexer, and two bit lines electrically connected to every two adjacent columns of second ferroelectric memory cells are electrically connected to the second multiplexer.

Based on a size of the sense amplifier, two consecutive adjacent columns of ferroelectric memory cells may be disposed opposite to the sense amplifier. In this way, a bit line electrically connected to a part of ferroelectric memory cells can be electrically connected to the multiplexer without a need to extend in a row direction, to avoid affecting strength of a read signal due to a great increase in a capacitance value of a bit line capacitance caused by lengthening of the bit line BL.

Although two columns of first ferroelectric memory cells in a ferroelectric memory array may send read signals to a same first multiplexer, and two columns of second ferroelectric memory cells in the ferroelectric memory array may send read signals to a same second multiplexer, because two adjacent columns of ferroelectric memory cells in the ferroelectric memory array read read signals in a time division manner, there is no case in which a plurality of ferroelectric memory cells simultaneously send the read signals to the same first multiplexer or the same second multiplexer through a plurality of bit lines, and the plurality of bit lines do not need to sequentially transmit the read signals to the first multiplexer or the same second multiplexer. This can avoid a case in which the read signals finally received by the sense amplifier becomes weak due to losses of the read signals in a process of waiting to be transmitted to the first multiplexer or the same second multiplexer, and can further shorten total time of the read phase, to improve read efficiency.

In addition, there is always an even column of ferroelectric memory cells spaced between every two adjacent odd columns of ferroelectric memory cells; and there is always an odd column of ferroelectric memory cells spaced between every two adjacent even columns of ferroelectric memory cells. Therefore, a problem of mutual coupling between the signals on the bit lines that are electrically connected to the two adjacent columns of ferroelectric memory cells in the read phase can be avoided, and strength of the read signals is not affected. On this basis, in a phase of reading the odd column, a low level may be further provided for the bit line electrically connected to the even column of ferroelectric memory cells, so that the bit line electrically connected to the even column of ferroelectric memory cells is in a shielded state, to shield coupling between both sides of the odd column and the bit line electrically connected to the odd column of ferroelectric memory cells, so as to further resolve the foregoing coupling problem. Similarly, in a phase of reading the even column, a low level may be further provided for the bit line electrically connected to the odd column of ferroelectric memory cells.

In addition, because the problem of mutual coupling between the signals on the bit lines that are electrically connected to the two adjacent columns of ferroelectric memory cells in the read phase is resolved, there is no need to use a large-area ferroelectric capacitor to reduce read signal interference caused by coupling, so that a layout area of the ferroelectric capacitor and even a layout area of the ferroelectric random access memory can be reduced.

In some possible implementations, the ferroelectric random access memory further includes a plurality of word lines; and in the plurality of ferroelectric memory cells, gates of first transistors in one row of ferroelectric memory cells are electrically connected to a same word line in a row direction. In this way, a first transistor of the i^{th} column of ferroelectric memory cells and the second transistor electrically connected to the ith plate line may be simultaneously turned on, and no additional conducting wire that drives the second transistor to be turned on is needed.

In some possible implementations, the ferroelectric random access memory further includes an ith plate line selector; and the ith plate line selector is electrically connected to the ith plate line, and is configured to send the high level to the ith plate line in the read phase. This application may use the ith plate line selector.

Specifically, the ith plate line selector includes a second transistor, and both the first transistor and the second transistor are N-type transistors or P-type transistors; a gate of the second transistor in the ith plate line selector is electrically connected to the word line electrically connected to the ith plate line; and when data of the (m*n+i)^{th} column of ferroelectric memory cells is read, a source of the second transistor in the ith plate line selector inputs the high level to the ith plate line, and a voltage received by a source of another second transistor is 0 V Therefore, in a phase of reading the (m*n+i)^{th} column of ferroelectric memory cells, only the second transistor of the ith plate line selector inputs the high level to the (m*n+i)^{th} column of ferroelectric memory cells through the ith plate line, to read the read signal.

For example, in a phase of reading the (m*n+1)^{th} column of ferroelectric memory cells, only a second transistor of a first plate line selector inputs the high level to the (m*n+1)^{th} column of ferroelectric memory cells 10 through the first plate line PL 1, to read the read signal. A second transistor of another plate line selector inputs 0 V to a ferroelectric memory cell other than the (m*n+1)^{th} column of ferroelectric memory cells through another plate line. In this way, the ferroelectric memory cell other than the (m*n+1)^{th} column of ferroelectric memory cells has no signal to be read presently.

According to a third aspect, this application provides a terminal. The terminal includes a circuit board and the ferroelectric random access memory according to the first aspect or the second aspect, and the ferroelectric random access memory is disposed on the circuit board.

The third aspect and any implementation of the third aspect respectively correspond to the first aspect and any implementation of the first aspect or the second aspect and any implementation of the second aspect. For technical effects corresponding to the third aspect and any implementation of the third aspect, refer to technical effects corresponding to the first aspect, the second aspect, and any implementation of the first aspect and the second aspect. Details are not described herein again.

### BRIEF DESCRIPTION OF DRAWINGS

FIG. 1a is a circuit diagram of a 1T1C ferroelectric memory cell according to a related technology;
FIG. 1b is a circuit diagram of a 2T2C ferroelectric memory cell according to a related technology;
FIG. 2a is a diagram of movement of a charge in a ferroelectric capacitor according to a related technology;
FIG. 2b is a diagram of movement of a charge in a ferroelectric capacitor according to a related technology;
FIG. 3 is a diagram of a relationship between a coercive field voltage and a residual polarization charge quantity according to a related technology;
FIG. 4 is a working timing diagram of the ferroelectric memory cell in FIG. 1a;
FIG. 5 is a circuit diagram of a ferroelectric random access memory according to a related technology;
FIG. 6 is a circuit diagram of another ferroelectric random access memory according to a related technology;
FIG. 7a is a circuit diagram of a ferroelectric random access memory according to an embodiment of this application;
FIG. 7b is a circuit diagram of another ferroelectric random access memory according to an embodiment of this application;
FIG. 8 is a circuit diagram of another ferroelectric random access memory according to an embodiment of this application;
FIG. 9a is a circuit diagram of another ferroelectric random access memory according to an embodiment of this application; and
FIG. 9b is a circuit diagram of another ferroelectric random access memory according to an embodiment of this application.

Reference numerals:
10: ferroelectric memory cell; 101: ferroelectric memory array; 20: multiplexer; 21: first multiplexer; 22: second multiplexer; 31: first ferroelectric memory cell; and 32: second ferroelectric memory cell.

### DESCRIPTION OF EMBODIMENTS

To make objectives, technical solutions, and advantages of this application clearer, the following clearly and completely describes the technical solutions in this application with reference to the accompanying drawings in this application. It is clear that described embodiments are some rather than all of embodiments of this application. All other embodiments obtained by a person of ordinary skill in the art based on embodiments of this application without creative efforts shall fall within the protection scope of this application.

In the specification, embodiments, claims, and accompanying drawings of this application, the terms "first", "second", and the like are merely intended for distinguishing and description, and shall not be understood as indicating or implying relative importance, or indicating or implying a sequence. The term "and/or" is used for describing an association relationship between associated objects, and indicates that three relationships may exist. For example, "A and/or B" may indicate the following three cases: Only A exists, only B exists, and both A and B exist, where A and B may be singular or plural. The character "/" generally indicates an "or" relationship between the associated objects. "Mounting", "connection", "being connected to", and the like should be understood in a broad sense, for example, may be a fixed connection, a detachable connection, or an integral connection; or may be a direct connection, an indirect connection through an intermediate medium, or internal communication between two elements. In addition, the terms "include", "have", and any variant thereof are intended to cover non-exclusive inclusion, for example, include a series of steps or units. For example, methods, systems, products, or devices are not necessarily limited to those steps or units expressly listed, but may include other steps or units not expressly listed or inherent to such processes, methods, products, or devices. "Up", "down", "left", "right", and the like are used only relative to the orientation of the components in the accompanying drawings. These directional terms are relative concepts, are used for relative descriptions and clarifications, and may change accordingly as positions at which the components in the accompanying drawings are placed change.

An embodiment of this application provides a terminal. The terminal may be a device having a storage function, for example, a mobile phone, a computer, a tablet computer, a personal digital assistant (personal digital assistant, PDAfor short), a smart wearable device, or a smart home device. This is not limited in embodiments of this application. For ease of description, the following uses the mobile phone as an example for description.

The mobile phone may include a processor and a memory. The memory may be configured to store computer-executable program code, and the computer-executable code may include instructions. The processor runs the instructions stored in the memory, to perform various function applications and data processing of the mobile phone. In some embodiments, the memory may further store instructions or data just used or cyclically used by the processor. If the processor needs to use the instructions or the data again, the processor may directly invoke the instructions or the data from the memory. This avoids repeated access, reduces waiting time of the processor, and improves working efficiency of the mobile phone.

To improve the working efficiency of the mobile phone, a ferroelectric random access memory gradually replaces another storage device because of advantages of the ferroelectric random access memory, such as high-speed read/write, high-density storage, low power consumption, and radiation resistance.

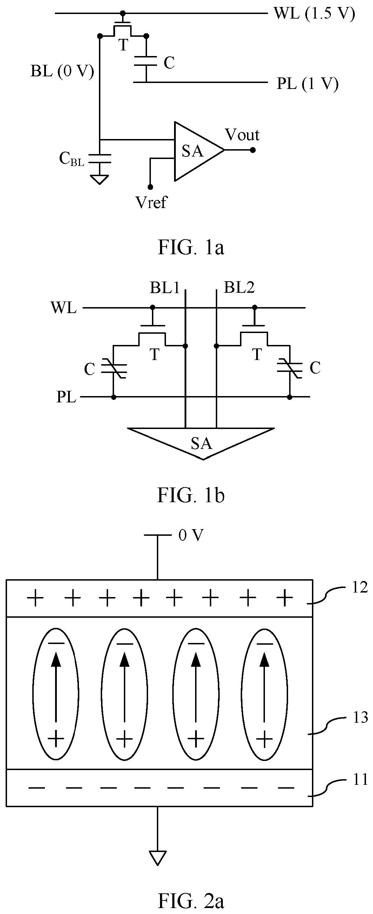

As shown in FIG. 1a and FIG. 1b, the ferroelectric random access memory may include a word line WL, a bit line BL, a plate line PL, and a plurality of ferroelectric memory cells, and each ferroelectric memory cell includes at least one ferroelectric capacitor C and at least one transistor T. A first electrode of the ferroelectric capacitor C is electrically connected to a first electrode of the transistor T, and a second electrode of the ferroelectric capacitor C is electrically connected to the plate line PL. A gate of the transistor T is electrically connected to the word line WL, the first electrode of the transistor T is electrically connected to the plate line PL through the ferroelectric capacitor C, and a second electrode of the transistor T is electrically connected to the bit line BL.

The first electrode of the transistor T is a source, and the second electrode of the transistor T is a drain. Alternatively, the first electrode of the transistor T is a drain, and the second electrode of the transistor T is a source. The transistor T may be an N-type transistor or a P-type transistor. If the transistor T is an N-type transistor, when the word line WL inputs a high level to the gate of the transistor T, the transistor T is turned on; and when the word line WL inputs a low level to the gate of the transistor T, the transistor T is turned off. If the transistor T is a P-type transistor, when the word line WL inputs a low level to the gate of the transistor T, the transistor T is turned on; and when the word line WL inputs a high level to the gate of the transistor T, the transistor T is turned off. For ease of description, the following uses an example in which the transistor T is an N-type transistor for description.

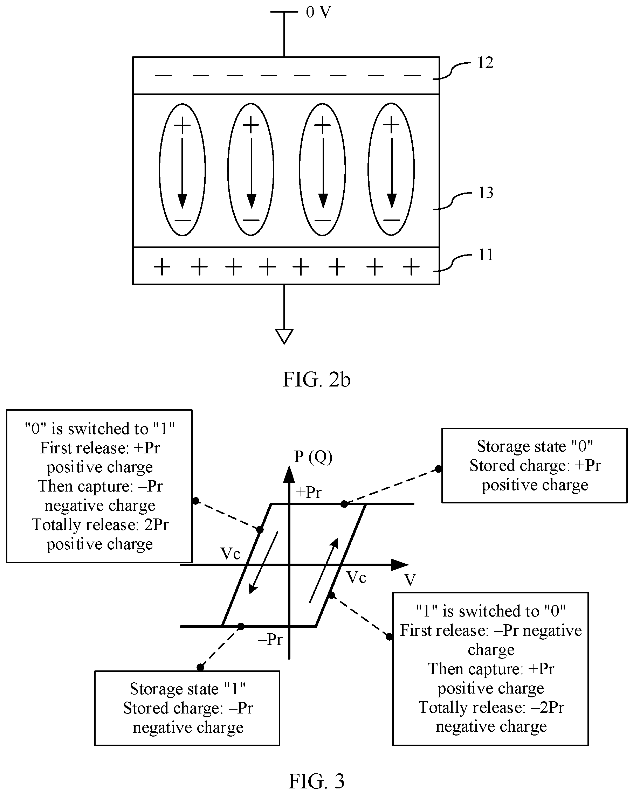

As shown in FIG. 2a and FIG. 2b, in addition to a first electrode 11 and a second electrode 12, the ferroelectric capacitor C may further include a ferroelectric function layer 13 disposed between the first electrode 11 and the second electrode 12. The ferroelectric function layer 13 may generate polarization based on a direction and a magnitude of an external applied electric field. After the electric field is removed, partial polarization may still be maintained, and the partial polarization is referred to as residual polarization. Because the residual polarization has a residual polarization charge quantity Pr, the residual polarization has an electric potential difference. As shown in FIG. 2a and FIG. 2b, to balance the electric potential difference, the first electrode 11 and the second electrode 12 may induce opposite inductive charges. After the electric field is removed, the residual polarization is not lost. Therefore, the inductive charges may still be kept on the first electrode 11 and the second electrode 12, and the ferroelectric random access memory may store non-volatile information by reading the inductive charges.

As shown in FIG. 3, when a reverse electric field is applied and an electric field strength exceeds that of a coercive field, polarization switching occurs. A quantity of charges released in a switching process of the ferroelectric capacitor C is identified, to read information stored in the capacitor C. A center voltage in the polarization switching process of the ferroelectric capacitor C is referred to as a coercive voltage Vc. To ensure reliability of the information stored in the ferroelectric capacitor C, the ferroelectric function layer 13 needs to be fully switched. In a write phase and a read phase, an electric potential difference input to the first electrode and the second electrode needs to be 2 times to 4 times the coercive voltage Vc.

The following describes working processes of the ferroelectric memory cell in the write phase and the read phase by using an example in which the ferroelectric memory cell includes one transistor T and one ferroelectric capacitor C (1T1C) and an example in which the ferroelectric memory cell includes two transistors T and two ferroelectric capacitors C (2T2C).

1T1C and writing 1 are used as an example. As shown in FIG. 1a, in the write phase, an electrical potential on the word line WL is a high level (for example, 1.5 V), and the transistor T is turned on. An electrical potential on the plate line PL is a high level (for example, 1 V), an electrical potential on the bit line BL is a low level (for example, 0 V), and 0 may be first written into the ferroelectric memory cell. Then, the electrical potential on the plate line PL is a low level, the electrical potential on the bit line BL is a high level, and 1 is written into the ferroelectric memory cell.

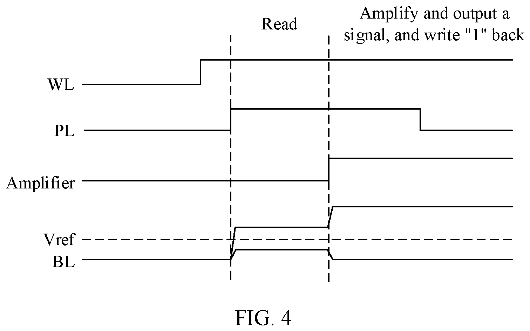

As shown in FIG. 4, in the read phase, the electrical potential on the word line WL is a high level, and the transistor T is turned on. The electrical potential on the plate line PL is a high level, and the electrical potential on the bit line BL is a low level. A charge at the ferroelectric function layer 13 is switched, and a switched charge is released as a read signal. The switched charge is input to a multiplexer in a form of voltage through a bit line capacitance C_{BL} electrically connected to the bit line BL, and is input to a sense amplifier (sense amplifier, SA) through the multiplexer. The sense amplifier SA may compare the read signal with a reference voltage Vref, to identify that the read signal is 1, and may further amplify the read signal.

1T1C and writing 0 are used as an example. As shown in FIG. 1a, in the write phase, an electrical potential on the word line WL is a high level (for example, 1.5 V), and the transistor T is turned on. An electrical potential on the plate line PL is a high level (for example, 1 V), an electrical potential on the bit line BL is a low level (for example, 0 V), and 0 may be written into the ferroelectric memory cell.

As shown in FIG. 4, in the read phase, the electrical potential on the word line WL is a high level, and the transistor T is turned on. The electrical potential on the plate line PL is a high level, and the electrical potential on the bit line BL is a low level. Because a direction of an electric field applied to the first electrode 11 and the second electrode 12 does not change in the write phase and the read phase, a charge at the ferroelectric function layer 13 is not switched, and the charge is not released. The read signal of the unreleased charge is transmitted to the multiplexer through the bit line BL, and is input to the sense amplifier SA through the multiplexer. The sense amplifier SA may compare the read signal with the reference voltage Vref, to identify that the read signal is 0.

A person skilled in the art needs to know that, when the memory cell can work normally, the sense amplifier SA may determine, based on a comparison result "the read signal is greater than the reference voltage Vref", that the read signal is 1. Otherwise, the sense amplifier SA may determine, based on a comparison result "the read signal is less than the reference voltage Vref", that the read signal is 0.

2T2C is used as an example. As shown in FIG. 1b, the ferroelectric memory cell may include a first ferroelectric memory cell and a second ferroelectric memory cell, and each of the first ferroelectric memory cell and the second ferroelectric memory cell includes one transistor T and one ferroelectric capacitor C. In the write phase, an electrical potential on the word line WL is a high level, and two transistors T are turned on. An electrical potential on the plate line PL is a high level, an electrical potential on the bit line BL is a low level, and 0 may be first written into the first ferroelectric memory cell and the second ferroelectric memory cell. Then, the electrical potential on the plate line PL is a low level, an electrical potential on a bit line BL electrically connected to the first ferroelectric memory cell is a high level, and 1 is written into the first ferroelectric memory cell. Because the bit line BL electrically connected to the first ferroelectric memory cell and a bit line BL electrically connected to the second ferroelectric memory cell are mutually insulated, in a phase of writing 1 into the first ferroelectric memory cell, the second ferroelectric memory cell still keeps 0.

In the read phase, the electrical potential on the word line WL is a high level, and the transistor T is turned on. The electrical potential on the plate line PL is a high level, and the electrical potential on the bit line BL is a low level. A charge at a ferroelectric function layer 13 of the first ferroelectric memory cell is switched, and a switched charge is released as a first read signal; and a charge at a ferroelectric function layer 13 of the second ferroelectric memory cell is not switched, and the charge is not released. The bit line BL transmits, to the multiplexer, the first read signal and a second read signal obtained when the charge is not released, and inputs the first read signal and the second read signal to two input ends of the sense amplifier SA through the multiplexer. The first read signal and the second read signal may be compared with each other, to determine that the first read signal is 1 and the second read signal is 0.

Compared with the 1T1C ferroelectric random access memory, the 2T2C ferroelectric random access memory may determine that the first read signal is 1 and the second read signal is 0 without using the reference voltage Vref. In addition, a difference between the first read signal and the second read signal is a difference between the first read signal and the reference voltage Vref and twice a difference between the second read signal and the reference voltage Vref, so that it can be more accurately determined that the first read signal is 1 and the second read signal is 0. However, in comparison with the 2T2C ferroelectric random access memory, in the 1T1C ferroelectric random access memory, each memory cell has a smaller layout area, and the area is half of a layout area of a memory cell in the 2T2C ferroelectric random access memory.

As mentioned in the background, when the read signal (or the first read signal and the second read signal) is (are) read by using a circuit structure of the ferroelectric random access memory provided in the related technology, a series of problems exist.

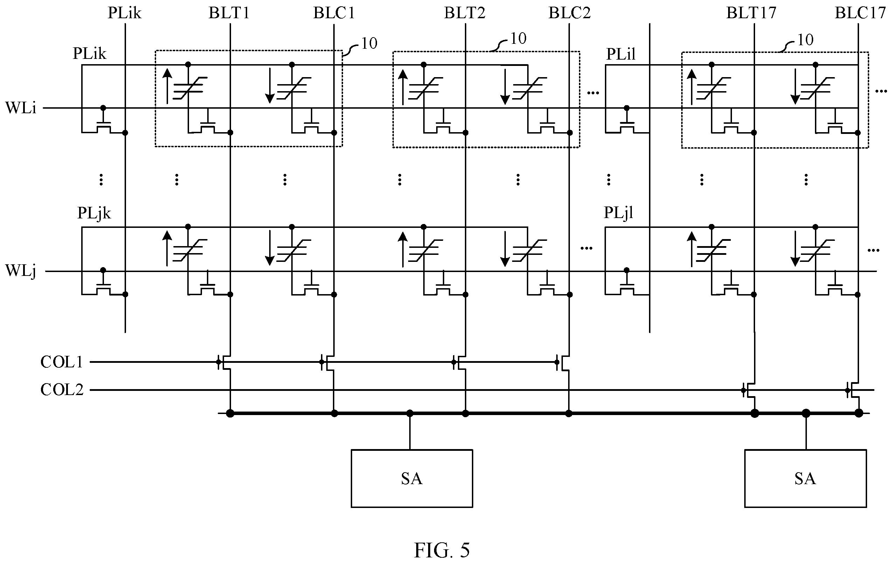

For example, as shown in FIG. 5, the ferroelectric random access memory includes a plurality of ferroelectric memory cells 10 arranged in array, and the plurality of memory cells are all 2T2C memory cells. Each ferroelectric memory cell 10 includes a first ferroelectric memory cell and a second ferroelectric memory cell, and each of the first ferroelectric memory cell and the second ferroelectric memory cell includes one transistor T and one ferroelectric capacitor C. For example, the plurality of ferroelectric memory cells 10 arranged in array are grouped into two ferroelectric memory arrays, and each ferroelectric memory array includes 16 columns of ferroelectric memory cells 10. The 1^{st} column of ferroelectric memory cells 10 and the 17^{th} column of ferroelectric memory cells 10 are electrically connected to a same sense amplifier SA, the 2^{nd} column of ferroelectric memory cells 10 and the 18^{th} column of ferroelectric memory cells 10 are electrically connected to a same sense amplifier SA, and so on. A circuit structure of the ferroelectric random access memory has the following two problems.

First, the 1^{st} column of ferroelectric memory cells 10 and the 17^{th} column of ferroelectric memory cells 10 are used as an example. There are further 15 columns of ferroelectric memory cells 10 spaced between the two columns of ferroelectric memory cells 10 electrically connected to the same sense amplifier SA, and in layout design, due to a size limitation of the sense amplifier SA, the sense amplifier SA cannot be disposed opposite to the 1^{st} column of ferroelectric memory cells 10 and the 17^{th} column of ferroelectric memory cells 10 by crossing a width of the 15 columns of ferroelectric memory cells 10. Therefore, a bit line BL electrically connected to the 1^{st} column of ferroelectric memory cells 10 further needs to extend in a direction from the 1^{st} column of ferroelectric memory cells 10 to the 17^{th} column of ferroelectric memory cells 10, and/or a bit line BL of the 17^{th} column of ferroelectric memory cells 10 further needs to extend in a direction from the 17^{th} column of ferroelectric memory cells 10 to the 1^{st} column of ferroelectric memory cells 10 (for an extended part of the bit line BL, refer to a bold line in FIG. 5), resulting in increasing of a total length of the bit line BL.

Because the ferroelectric random access memory is a charge-type device, strength of the read signal (or the first read signal and the second read signal) read by the ferroelectric random access memory depends on a ratio of a charge quantity released by the ferroelectric capacitor C to the bit line capacitance C_{BL}. Because the total length of the bit line BL becomes greater, a capacitance value of the bit line capacitance C_{BL} also greatly increases. This affects the strength of the read signal (or the first read signal and the second read signal).

Second, still as shown in FIG. 5, a second ferroelectric memory cell in the 1^{st} column of ferroelectric memory cells 10 and a first ferroelectric memory cell in the 2^{nd} column of ferroelectric memory cells 10 are adjacently disposed. In the read phase, the 1^{st} column of ferroelectric memory cells 10 and the 2^{nd} column of ferroelectric memory cells 10 that are in a same row read signals simultaneously, and the second read signal transmitted by a bit line BLC1 electrically connected to the second ferroelectric memory cell in the 1^{st} column of ferroelectric memory cells 10 is opposite to the first read signal transmitted by a bit line BLT2 electrically connected to the first ferroelectric memory cell in the 2^{nd} column of ferroelectric memory cells 10. For example, the second read signal transmitted by the bit line BLC1 electrically connected to the second ferroelectric memory cell in the 1^{st} column of ferroelectric memory cells 10 is 1, and the first read signal transmitted by the bit line BLT2 electrically connected to the first ferroelectric memory cell in the 2^{nd} column of ferroelectric memory cells 10 is 0; or the second read signal transmitted by the bit line BLC1 electrically connected to the second ferroelectric memory cell in the 1^{st} column of ferroelectric memory cells 10 is 0, and the first read signal transmitted by the bit line BLT2 electrically connected to the first ferroelectric memory cell in the 2^{nd} column of ferroelectric memory cells 10 is 1.

However, in the read phase, a circuit used to drive the bit line BL is disconnected from the bit line BL, and the bit line BL is in a floating (floating) state. In this case, the bit line BL may be considered as a capacitor, and easily converts a charge into a voltage, but is also easily interfered. Therefore, as shown in FIG. 5, when the bit line BLC1 and the bit line BLT2 that are adjacent to each other transmit opposite signals, the bit line BLC1 and the bit line BLT2 are coupled to each other (coupling). This severely affects strength of the second read signal transmitted by the bit line BLC1 and strength of the first read signal transmitted by the bit line BLT2. For example, when 00010000 is read by using the ferroelectric random access memory shown in FIG. 5, because both the 3^{rd} bit and the 5^{th} bit are 0, and due to coupling between adjacent bit lines BL, a bit line BL reading 0 pulls down a bit line BL reading 1, a read voltage of reading 1 at the 4^{th} bit is less than a read voltage of reading 1 at the 4^{th} bit in the 11111111.

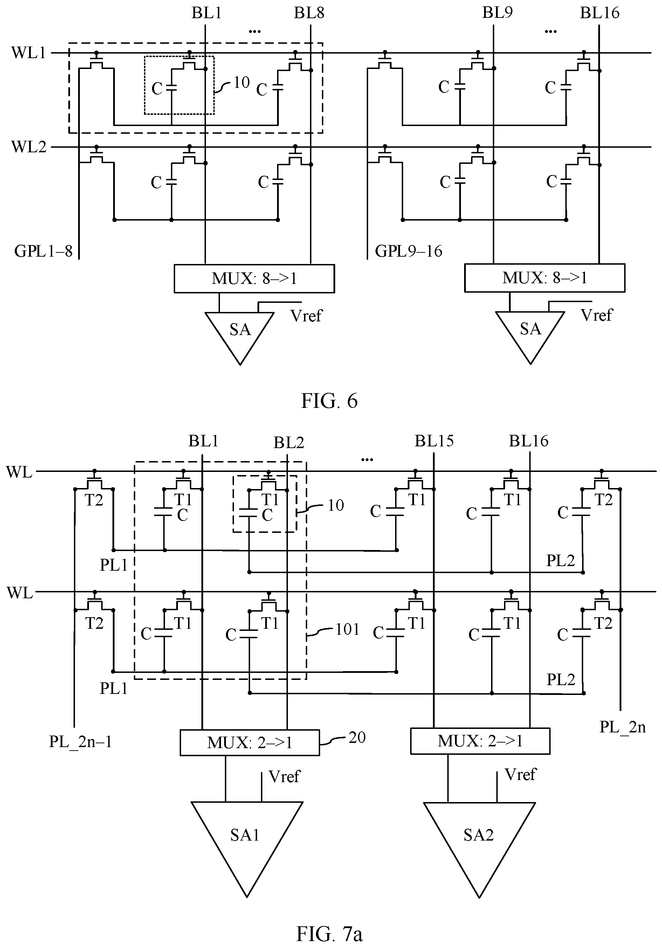

For another example, to resolve a problem that the total length of the bit line BL becomes greater, a circuit structure of another ferroelectric random access memory is further proposed in the related technology. As shown in FIG. 6, the ferroelectric random access memory includes a plurality of ferroelectric memory cells 10 arranged in array. Each ferroelectric memory cell 10 includes one transistor T and one ferroelectric capacitor C. The plurality of ferroelectric memory cells 10 may be divided into a plurality of ferroelectric memory arrays. Each ferroelectric memory array includes eight adjacent columns of ferroelectric memory cells 10. The eight columns of ferroelectric memory cells 10 in a ferroelectric memory array are electrically connected to one multiplexer and one sense amplifier SA. Although the sense amplifier SA can be directly disposed opposite to the eight adjacent columns of ferroelectric memory cells without a need to cross a plurality of columns of ferroelectric memory cells, to resolve the problem that the total length of the bit line BL is increased, the circuit structure of the ferroelectric random access memory still has the following three problems.

First, signals written into ferroelectric memory cells 10 that are in two adjacent columns and that are in a same row may be different, and in the read phase, read signals on two bit lines BL electrically connected to the two adjacent columns of ferroelectric memory cells 10 are also different. For example, a read signal transmitted by a bit line BL1 electrically connected to the 1^{st} column of ferroelectric memory cells 10 is 1, and a read signal transmitted by a bit line BL2 electrically connected to the 2^{nd} column of ferroelectric memory cells 10 is 1.

However, in the read phase, a circuit used to drive the bit line BL is disconnected from the bit line BL, and the bit line BL is in a floating state. In this case, the bit line BL may be considered as a capacitor, and easily converts a charge into a voltage, but is also easily interfered. Therefore, as shown in FIG. 6, when the bit line BL1 and the bit line BL2 that are adjacent to each other transmit opposite signals, the bit line BL1 and the bit line BL2 are coupled to each other. This severely affects strength of the read signals transmitted by the bit line BL1 and the bit line BL2.

Second, because the multiplexer is electrically connected to eight columns of ferroelectric memory cells 10 in a ferroelectric memory array, and the eight ferroelectric memory cells 10 in a same row of the ferroelectric memory array are electrically connected to a same plate line PL, the sense amplifier SA needs to work repeatedly eight times to receive 8 bits data of the eight ferroelectric memory cells 10 one by one. This affects a reading speed.

Third, because the sense amplifier SA receives read signals of the eight ferroelectric memory cells 10 one by one, the bit line BL1 to a bit line BL8 transmit the read signals in a time sequence, where a charge quantity on the bit line BL that is received later may be lost in a process of waiting to be transmitted to the sense amplifier SA, and consequently, a read signal finally received by the sense amplifier SA becomes weak.

In addition, in some related technologies, to resolve the foregoing problem that the adjacent bit lines are coupled to each other when signals are read, a layout area of the ferroelectric capacitor C is increased. However, this causes a layout area of the ferroelectric random access memory including a plurality of ferroelectric capacitors C to be greatly increased.

The foregoing column direction may be an extension direction of any bit line BL in each ferroelectric memory cell 10, and is unrelated to a disposing position of the ferroelectric random access memory. In addition, a row direction mentioned below may be a direction perpendicular to the column direction.

Based on the foregoing problem, as shown in FIG. 7a to FIG. 8, an embodiment of this application provides a ferroelectric random access memory. The ferroelectric random access memory includes a plurality of bit lines BL, an ith plate line PL, a multiplexer 20, a sense amplifier SA, and a plurality of ferroelectric memory cells 10. The plurality of ferroelectric memory cells 10 are grouped into at least one ferroelectric memory array 101. Each ferroelectric memory array 101 includes a plurality of ferroelectric memory cells 10 arranged in array. The ferroelectric memory cell 10 includes one ferroelectric capacitor C and one first transistor T1.

In any row of the ferroelectric memory array 101, a ferroelectric capacitor C of the (m*n+i)^{th} column of ferroelectric memory cells 10 is electrically connected to the ith plate line PL. In a read phase, each plate line PL in the ith plate line PL inputs a high level to the ferroelectric memory cell 10 in a time division manner, where m is an integer greater than or equal to 2, n is an integer greater than or equal to 0, and i is a positive integer less than or equal to m. In the plurality of ferroelectric memory cells 10, first transistors T1 of each column of ferroelectric memory cells 10 are electrically connected to one of the bit lines BL, and m bit lines BL electrically connected to every m adjacent columns of ferroelectric memory cells 10 are electrically connected to a same multiplexer 20. One input end of each sense amplifier is electrically connected to an output end of one multiplexer, and another input end of the sense amplifier is configured to receive a reference voltage.

Ferroelectric memory cells 10 in a ferroelectric memory array 101 are arranged in array. In this case, the ferroelectric memory array 101 includes at least two adjacent columns of ferroelectric memory cells 10, that is, m is an integer greater than or equal to 2.

In some possible implementations, a quantity m of columns and a quantity of rows of ferroelectric memory cells 10 in the ferroelectric memory array 101 are not limited in embodiments of this application.

Optionally, the quantity m of columns of ferroelectric memory cells 10 in the ferroelectric memory array 101 may be determined based on a size of the sense amplifier SA, so that m consecutive adjacent columns of ferroelectric memory cells 10 may be disposed opposite to the sense amplifier SA. In this way, a bit line BL electrically connected to a part of ferroelectric memory cells 10 can be electrically connected to the sense amplifier SA without a need to extend in a row direction, to avoid a case in which a capacitance value of a bit line capacitance C_{BL} is greatly increased due to lengthening of the bit line BL, and strength of a read signal is affected. For example, m may be equal to 2 or 4. Certainly, when the size of the sense amplifier SA is large enough, and the m consecutive adjacent columns of ferroelectric memory cells 10 may be disposed opposite to the sense amplifier SA, m may alternatively be another value. This is not limited in embodiments of this application.

Optionally, the quantity of rows of ferroelectric memory cells 10 in the ferroelectric memory array 101 may be equal to a total quantity of rows of ferroelectric memory cells 10 in the ferroelectric random access memory.

A person skilled in the art needs to know that, when a ferroelectric memory array 101 includes a plurality of rows of ferroelectric memory cells 10, the plurality of rows of ferroelectric memory cells 10 in the ferroelectric memory array 101 need to read signals row by row in a time division manner.

In some possible implementations, a value of n is not limited in embodiments of this application. The value of n is related to a total quantity of the plurality of ferroelectric memory cells 10 in the ferroelectric random access memory and a quantity of ferroelectric memory cells 10 in a ferroelectric memory array 101. For example, n may be 0, 1, 2, or 3.

The following separately uses m=2 and m=4 as examples to describe a working process of the ferroelectric random access memory in the read phase in embodiments of this application.

As shown in FIG. 7a, for example, m=2, the ferroelectric random access memory includes 16 columns of ferroelectric memory cells 10, and the 16 columns of ferroelectric memory cells 10 are grouped into eight ferroelectric memory arrays 101. Each ferroelectric memory array 101 includes two columns of ferroelectric memory cells 10, and each ferroelectric memory cell 10 includes one first transistor T1 and one ferroelectric capacitor C. The ferroelectric random access memory may further include a plurality of word lines WL, a first electrode 11 of the ferroelectric capacitor C is electrically connected to a first electrode of the first transistor T1, and a second electrode 12 of the ferroelectric capacitor C is electrically connected to the ith plate line. A gate of the first transistor T1 is electrically connected to a word line WL, the first electrode of the first transistor T1 is electrically connected to the ith plate line through the ferroelectric capacitor C, and a second electrode of the first transistor T1 is electrically connected to a bit line BL.

In any row of the ferroelectric memory cells 10, a ferroelectric capacitor C of an odd column of ferroelectric memory cells 10 is electrically connected to a first plate line PL1 in the ith plate line, and a ferroelectric capacitor C of in an even column of ferroelectric memory cells 10 is electrically connected to a second plate line PL2 in the ith plate line. In the ferroelectric random access memory, first transistors T1 of each column of ferroelectric memory cells 10 may be electrically connected to one of the bit lines BL. For example, the 1^{st} column of ferroelectric memory cells 10 are electrically connected to a bit line BL1, the 2^{nd} column of ferroelectric memory cells 10 are electrically connected to a bit line BL2, ..., and the 16^{th} column of ferroelectric memory cells 10 are electrically connected to a bit line BL16.

Based on a circuit structure of the ferroelectric random access memory, for any row of the ferroelectric random access memory, in the read phase, the first plate line PL1 and the second plate line PL2 may be first controlled to input a high level to the 16 columns of ferroelectric memory cells 10 in a time division manner, to read signals. To be specific, the first plate line PL1 first inputs a high level to eight odd columns of ferroelectric memory cells 10, and bit lines electrically connected to the eight odd columns of ferroelectric memory cells 10 input a low level to the eight odd columns of ferroelectric memory cells 10. Then, the low level is cut off, so that the bit lines electrically connected to the eight odd columns of ferroelectric memory cells 10 are in a floating state, and read signals of the eight odd columns of ferroelectric memory cells 10 are sent to eight multiplexers 20 respectively through the bit lines.

Then, the second plate line PL2 inputs a high level to eight even columns of ferroelectric memory cells 10, and bit lines electrically connected to the eight even columns of ferroelectric memory cells 10 input a low level to the eight even columns of ferroelectric memory cells 10. Then, the low level is cut off, so that the bit lines electrically connected to the eight even columns of ferroelectric memory cells 10 are in a floating state, and read signals of the eight even columns of ferroelectric memory cells 10 are sent to the eight multiplexers 20 respectively through the bit lines.

Although two adjacent columns of ferroelectric memory cells 10 in a ferroelectric memory array 101 may send read signals to a same multiplexer 20, because the two adjacent columns of ferroelectric memory cells 10 in the ferroelectric memory array 101 read the read signals in a time division manner, there is no case in which a plurality of ferroelectric memory cells 10 simultaneously send read signals to a same multiplexer 20 through a plurality of bit lines, and the plurality of bit lines do not need to sequentially transmit the read signals to the multiplexer 20. This can avoid a case in which the read signals finally received by the sense amplifier SA become weak due to losses of the read signals in a process of waiting to be transmitted to the multiplexer 20, and can further shorten total time of the read phase, to improve read efficiency.

In addition, there is always an even column of ferroelectric memory cells 10 spaced between every two adjacent odd columns of ferroelectric memory cells 10; and there is always an odd column of ferroelectric memory cells 10 spaced between every two adjacent even columns of ferroelectric memory cells 10. This can avoid affecting strength of the read signals due to a problem of mutual coupling between the signals on the bit lines that are electrically connected to the two adjacent columns of ferroelectric memory cells 10 in the read phase. On this basis, in a phase of reading the odd column, a low level may be further provided for the bit line electrically connected to the even column of ferroelectric memory cells 10, so that the bit line electrically connected to the even column of ferroelectric memory cells 10 is in a shielded state, to shield coupling between both sides of the odd column and the bit line electrically connected to the odd column of ferroelectric memory cells 10, so as to further resolve the foregoing coupling problem. Similarly, in a phase of reading the even column, a low level may be further provided for the bit line electrically connected to the odd column of ferroelectric memory cells 10.

In addition, because the problem of mutual coupling between the signals on the bit lines that are electrically connected to the two adjacent columns of ferroelectric memory cells 10 in the read phase is resolved, there is no need to use a large-area ferroelectric capacitor C to reduce read signal interference caused by coupling, so that a layout area of the ferroelectric capacitor C and even a layout area of the ferroelectric random access memory can be reduced.

Based on the foregoing descriptions, after receiving the read signals of the eight odd columns of ferroelectric memory cells 10 respectively, the eight multiplexers 20 send the read signals to eight sense amplifiers SA, and the eight sense amplifiers SA may respectively compare the eight read signals with a reference voltage Vref, to determine that the eight read signals are 1 or 0. Then, after receiving the read signals of the eight even columns of ferroelectric memory cells 10 respectively, the eight multiplexers 20 send the read signals to the eight sense amplifiers SA, and the eight sense amplifiers SA may respectively compare the eight read signals with the reference voltage Vref, to determine that the eight read signals are 1 or 0.

For example, after receiving the read signal, the multiplexer 20 electrically connected to the 1^{st} column of ferroelectric memory cells 10 inputs the read signal to the 1^{st} sense amplifier SA1, and the 1^{st} sense amplifier SA1 compares the read signal with the reference voltage Vref, to determine that the read signal of the 1^{st} column of ferroelectric memory cells 10 is 0 or 1. Then, after receiving the read signal, the multiplexer 20 electrically connected to the 2^{nd} column of ferroelectric memory cells 10 inputs the read signal to the 1^{st} sense amplifier SA1, and the 1^{st} sense amplifier SA1 compares the read signal with the reference voltage Vref, to determine that the read signal of the 2^{nd} column of ferroelectric memory cells 10 is 0 or 1.

Similarly, a process of determining read signals of the 3^{rd} column to the 16^{th} column of ferroelectric memory cells 10 is the same as a process of determining the read signals of the 1^{st} column of ferroelectric memory cells 10 and the 2^{nd} column of ferroelectric memory cells 10. Details are not described herein again.

The foregoing example is described by using an example in which the read signals of the odd columns of ferroelectric memory cells 10 are first read, and then the read signals of the even columns of ferroelectric memory cells 10 are read. In some other possible implementations, the read signals of the even columns of ferroelectric memory cells 10 may be read first, and then the read signals of the odd columns of ferroelectric memory cells 10 may be read. Principles of a read process and a determining process in the read manner are the same as those in the foregoing example, and details are not described herein again.

In some possible implementations, the ferroelectric random access memory may further include a drive circuit and an ith plate line selector, and the drive circuit may send a high level or a low level to the ith plate line through the ith plate line selector.

Specifically, the ith plate line selector is electrically connected to the ith plate line, and is configured to send the high level to the ith plate line in the read phase. The ith plate line selector includes a second transistor T2, and both the second transistor T2 and the first transistor T1 may be N-type transistors, or both the second transistor T2 and the first transistor T1 may be P-type transistors. For ease of description, the following uses an example in which both the first transistor T1 and the second transistor T2 are N-type transistors for description.

A gate of the second transistor T2 in the ith plate line selector may be electrically connected to a word line WL electrically connected to the ith plate line. In this way, a first transistor T1 of the i^{th} column of ferroelectric memory cells 10 and the second transistor T2 electrically connected to the ith plate line may be simultaneously turned on, and no additional conducting wire that drives the second transistor T2 to be turned on is needed. When a read signal of the (m*n+i)^{th} column of ferroelectric memory cells 10 is read, a source of the second transistor T2 in the ith plate line selector inputs a high level to the ith plate line, and a voltage received by a source of another second transistor T2 is 0 V. Therefore, in a phase of reading the (m*n+i)^{th} column of ferroelectric memory cells 10, only the second transistor T2 of the ith plate line selector inputs the high level to the (m*n+i)^{th} column of ferroelectric memory cells 10 through the ith plate line, to read the read signal.

For example, in a phase of reading the (m*n+1)^{th} column of ferroelectric memory cells 10, only a second transistor T2 of a first plate line selector inputs the high level to the (m*n+1)^{th} column of ferroelectric memory cells 10 through the first plate line PL1, to read the read signal. A second transistor T2 of another plate line selector inputs 0 V to a ferroelectric memory cell 10 other than the (m*n+1)^{th} column of ferroelectric memory cells 10 through another plate line. In this way, the ferroelectric memory cell 10 other than the (m*n+1)^{th} column of ferroelectric memory cells 10 has no signal to be read presently.

In addition, the foregoing example shows a case in which the 16 columns of ferroelectric memory cells are grouped into the eight ferroelectric memory arrays 101. Optionally, in one ferroelectric random access memory, a quantity of 16-column ferroelectric memory cells 10 may be greater than 1. For example, one ferroelectric random access memory includes 1024 columns of ferroelectric memory cells 10 in total. In the 1024 columns of ferroelectric memory cells 10, a quantity of 16-column ferroelectric memory cells 10 is 64.

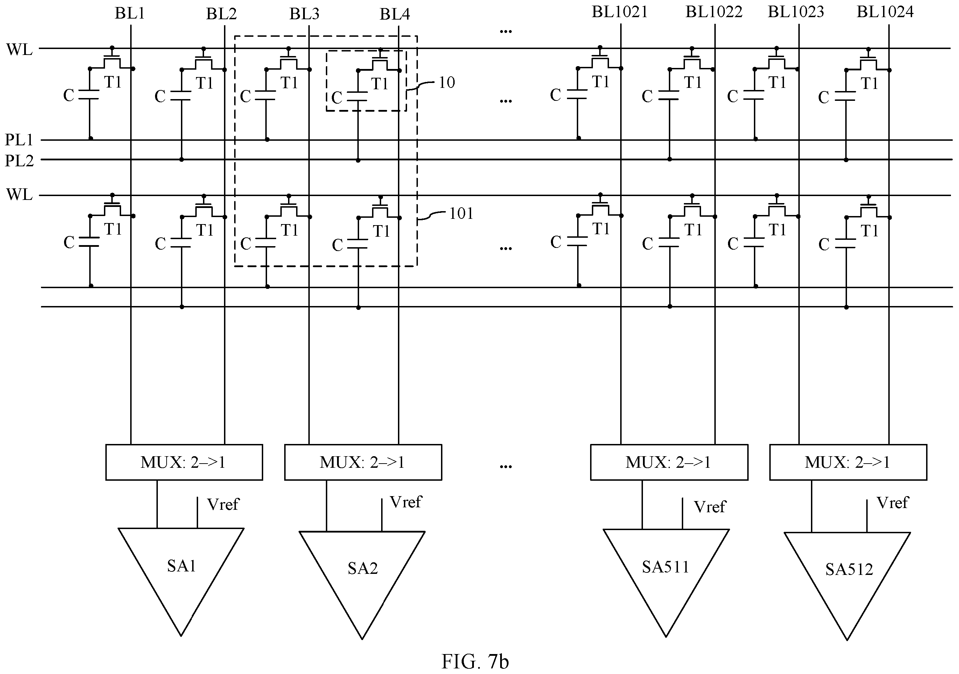

In some other possible implementations, as shown in FIG. 7b, an example in which one ferroelectric random access memory includes 1024 columns of ferroelectric memory cells 10 in total is still used. The 1024 columns of ferroelectric memory cells 10 may be divided into 512 ferroelectric memory arrays 101, and each ferroelectric memory array 101 includes two columns of ferroelectric memory cells 10, that is, m=2. The ith plate line may still include the first plate line PL1 and the second plate line PL2, the first plate line PL1 is still electrically connected to the odd column of ferroelectric memory cells 10, and the second plate line PL2 is still electrically connected to the even column of ferroelectric memory cells 10. A quantity of bit lines BL in the ferroelectric random access memory may be 1024, and the 1024 bit lines BL are electrically connected to the 1024 columns of ferroelectric memory cells 10 respectively. The ferroelectric random access memory may alternatively include 512 multiplexers 20 and 512 sense amplifiers SA. 512 bit lines BL electrically connected to 512 odd columns of ferroelectric memory cells 10 are electrically connected to the 512 multiplexers 20 and the 512 sense amplifiers SA, and the 512 bit lines BL electrically connected to 512 even columns of ferroelectric memory cells 10 are electrically connected to the 512 multiplexers 20 and the 512 sense amplifiers SA.

For driving the ith plate line to work, in one manner, the drive circuit may be used to send a high level or a low level to the ith plate line through the ith plate line selector. For a specific connection manner and a driving process, refer to the foregoing embodiments. Details are not described herein again.

In another manner, the drive circuit may alternatively be directly electrically connected to the ith plate line, and the drive circuit directly sends a high level or a low level to the ith plate line electrically connected to the drive circuit. Specifically, in this embodiment, although the ferroelectric random access memory includes the 1024 columns of ferroelectric memory cells 10, one row of ferroelectric memory cells 10 are electrically connected only to a first plate line PL1 or a second plate line PL2. Therefore, the drive circuit only needs to be electrically connected to the first plate line PL1 and the second plate line PL2, so that a high level or a low level can be directly sent to the row of ferroelectric memory cells 10 through the first plate line PL1 or the second plate line PL2. In comparison with a solution in which the drive circuit is electrically connected to the first plate line PL1 and the second plate line PL2 through a plate line selector, in this embodiment of this application, a high level or a low level may be sent to the first plate line PL1 and the second plate line PL2 more effectively.

In addition, principles of a read process and a determining process of the ferroelectric random access memory are the same as those in the foregoing example, and details are not described herein again.

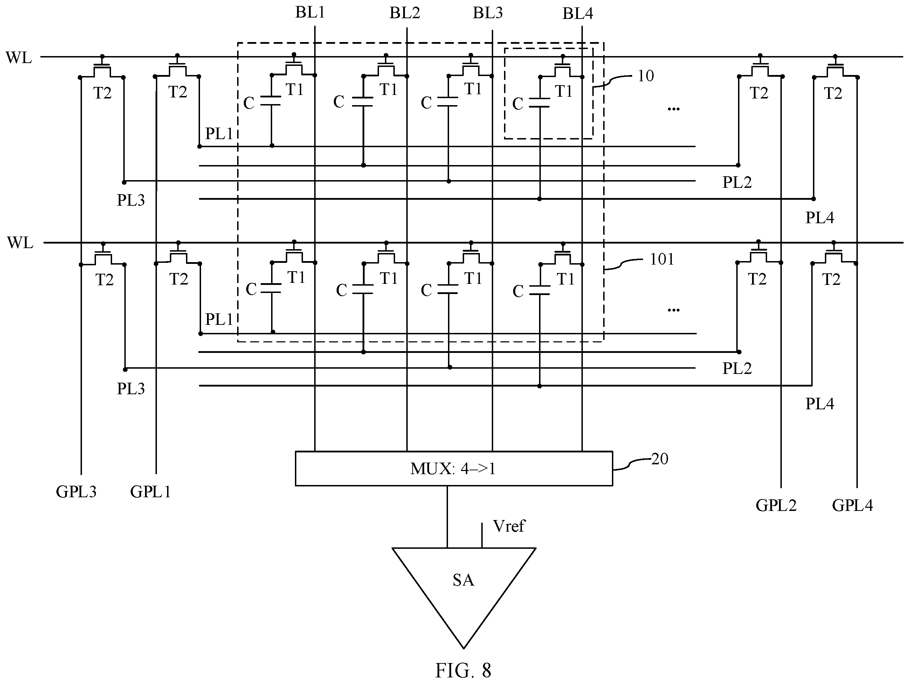

As shown in FIG. 8, for a sense amplifier SA of a large size, the sense amplifier SA may be further disposed opposite to more columns of ferroelectric memory cells 10. For example, the sense amplifier SA may be disposed opposite to four columns of ferroelectric memory cells 10.

Based on this, as shown in FIG. 8, for example, m=4, the ferroelectric random access memory includes 16 columns of ferroelectric memory cells 10, and the 16 columns of ferroelectric memory cells 10 are grouped into four ferroelectric memory arrays 101. Each ferroelectric memory array 101 includes four columns of ferroelectric memory cells 10, and each ferroelectric memory cell 10 includes one first transistor T1 and one ferroelectric capacitor C. A first electrode 11 of the ferroelectric capacitor C is electrically connected to a first electrode of the first transistor T1, and a second electrode 12 of the ferroelectric capacitor C is electrically connected to the ith plate line. A gate of the first transistor T1 is electrically connected to a word line WL, the first electrode of the first transistor T1 is electrically connected to the ith plate line through the ferroelectric capacitor C, and a second electrode of the first transistor T1 is electrically connected to a bit line BL.

In any row of the ferroelectric memory cells 10, a ferroelectric capacitor C of the (m*n+1)^{th} column of ferroelectric memory cells 10 is electrically connected to a first plate line PL1 in the ith plate line, a ferroelectric capacitor C of the (m*n+2)^{th} column of ferroelectric memory cells 10 is electrically connected to a second plate line PL2 in the ith plate line, a ferroelectric capacitor C of the (m*n+3)^{th} column of ferroelectric memory cells 10 is electrically connected to a third plate line PL3 in the ith plate line, and a ferroelectric capacitor C of the (m*n+4)^{th} column of ferroelectric memory cells 10 is electrically connected to a fourth plate line PL4 in the ith plate line. In the ferroelectric random access memory, first transistors T1 of each column of ferroelectric memory cells 10 may be electrically connected to one of the bit lines BL. For example, the 1^{st} column of ferroelectric memory cells 10 are electrically connected to a bit line BL1, the 2^{nd} column of ferroelectric memory cells 10 are electrically connected to a bit line BL2, ..., and the 16^{th} column of ferroelectric memory cells 10 are electrically connected to a bit line BL16.

Based on a circuit structure of the ferroelectric random access memory, for any row of the ferroelectric random access memory, in a read phase, the first plate line PL1 may be first controlled to input a high level to the 1^{st} column, the 5^{th} column, the 9^{th} column, and the 13^{th} column of ferroelectric memory cells 10, and bit lines electrically connected to the 1^{st} column, the 5^{th} column, the 9^{th} column, and the 13^{th} column of ferroelectric memory cells 10 input a low level to the 1^{st} column, the 5^{th} column, the 9^{th} column, and the 13^{th} column of ferroelectric memory cells 10. Then, the low level is cut off, so that the bit lines electrically connected to the 1^{st} column, the 5^{th} column, the 9^{th} column, and the 13^{th} column of ferroelectric memory cells 10 are in a floating state, and read signals of the 1^{st} column, the 5^{th} column, the 9^{th} column, and the 13^{th} column of ferroelectric memory cells 10 are respectively sent to four multiplexers 20 through the bit lines.

Then, the second plate line PL2 may be controlled to input a high level to the 2^{nd} column, the 6^{th} column, the 10^{th} column, and the 14^{th} column of ferroelectric memory cells 10, and bit lines electrically connected to the 2^{nd} column, the 6^{th} column, the 10^{th} column, and the 14^{th} column of ferroelectric memory cells 10 input a low level to the 2^{nd} column, the 6^{th} column, the 10^{th} column, and the 14^{th} column of ferroelectric memory cells 10. Then, the low level is cut off, so that the bit lines electrically connected to the 2^{nd} column, the 6^{th} column, the 10^{th} column, and the 14^{th} column of ferroelectric memory cells 10 are in a floating state, and read signals of the 2^{nd} column, the 6^{th} column, the 10^{th} column, and the 14^{th} column of ferroelectric memory cells 10 are respectively sent to the four multiplexers 20 through the bit lines.

Then, the third plate line PL3 may be controlled to input a high level to the 3^{rd} column, the 7^{th} column, the 11^{th} column, and the 15^{th} column of ferroelectric memory cells 10, and bit lines electrically connected to the 3^{rd} column, the 7^{th} column, the 11^{th} column, and the 15^{th} column of ferroelectric memory cells 10 input a low level to the 3^{rd} column, the 7^{th} column, the 11^{th} column, and the 15^{th} column of ferroelectric memory cells 10. Then, the low level is cut off, so that the bit lines electrically connected to the 3^{rd} column, the 7^{th} column, the 11^{th} column, and the 15^{th} column of ferroelectric memory cells 10 are in a floating state, and read signals of the 3^{rd} column, the 7^{th} column, the 11^{th} column, and the 15^{th} column of ferroelectric memory cells 10 are respectively sent to the four multiplexers 20 through the bit lines.

Then, the fourth plate line PL4 may be controlled to input a high level to the 4^{th} column, the 8^{th} column, the 12^{th} column, and the 16^{th} column of ferroelectric memory cells 10, and bit lines electrically connected to the 4^{th} column, the 8^{th} column, the 12^{th} column, and the 16^{th} column of ferroelectric memory cells 10 input a low level to the 4^{th} column, the 8^{th} column, the 12^{th} column, and the 16^{th} column of ferroelectric memory cells 10. Then, the low level is cut off, so that the bit lines electrically connected to the 4^{th} column, the 8^{th} column, the 12^{th} column, and the 16^{th} column of ferroelectric memory cells 10 are in a floating state, and read signals of the 4^{th} column, the 8^{th} column, the 12^{th} column, and the 16^{th} column of ferroelectric memory cells 10 are respectively sent to the four multiplexers 20 through the bit lines.

Although four adjacent columns of ferroelectric memory cells 10 in a ferroelectric memory array 101 may send read signals to a same multiplexer 20, because the four adjacent columns of ferroelectric memory cells 10 in the ferroelectric memory array 101 read the read signals in a time division manner, there is no case in which a plurality of ferroelectric memory cells 10 simultaneously send read signals to a same multiplexer 20 through a plurality of bit lines, and the plurality of bit lines do not need to sequentially transmit the read signals to the multiplexer 20. This can avoid a case in which the read signals finally received by the sense amplifier SA become weak due to losses of the read signals in a process of waiting to be transmitted to the multiplexer 20, and can further shorten total time of the read phase, to improve read efficiency.

In addition, there are further three columns of ferroelectric memory cells 10 spaced between every two columns of ferroelectric memory cells 10 whose read signals are simultaneously read. This can avoid affecting strength of the read signals due to a problem of mutual coupling between the signals on the bit lines that are electrically connected to the two adjacent columns of ferroelectric memory cells 10 in the read phase. On this basis, in a phase of reading the (m*n+1)^{th} column, a low level may be further provided for bit lines electrically connected to the (m*n+2)^{th} column, the (m*n+3)^{th} column, and the (m*n+4)^{th} column of ferroelectric memory cells 10, so that the bit lines electrically connected to the (m*n+2)^{th} column, the (m*n+3)^{th} column, and the (m*n+4)^{th} column of ferroelectric memory cells 10 are in a shielded state, to shield coupling between both sides of the (m*n+1)^{th} column and the bit line electrically connected to the (m*n+1)^{th} column of ferroelectric memory cells 10, so as to further resolve the foregoing coupling problem. Similarly, in a phase of reading the (m*n+2)^{th} column, or the (m*n+3)^{th} column, or the (m*n+4)^{th} column, the low level may be further provided for a bit line electrically connected to another column of ferroelectric memory cells 10.

In addition, because the problem of mutual coupling between the signals on the bit lines that are electrically connected to the two adjacent columns of ferroelectric memory cells 10 in the read phase is resolved, there is no need to use a large-area ferroelectric capacitor C to reduce read signal interference caused by coupling, so that a layout area of the ferroelectric capacitor C and even a layout area of the ferroelectric random access memory can be reduced.

Based on the foregoing descriptions, after receiving the read signals of the 1^{st} column, the 5^{th} column, the 9^{th} column, and the 13^{th} column of ferroelectric memory cells 10 respectively, the four multiplexers 20 send the four read signals to four sense amplifiers SA, and the four sense amplifiers SA may respectively compare the four read signals with a reference voltage Vref, to determine that the four read signals are 1 or 0. Then, after receiving the read signals of the 2^{nd} column, the 6^{th} column, the 10^{th} column, and the 14^{th} column of ferroelectric memory cells 10 respectively, the four multiplexers 20 send the four read signals to the four sense amplifiers SA, and the four sense amplifiers SA may respectively compare the four read signals with the reference voltage Vref, to determine that the four read signals are 1 or 0. Then, after receiving the read signals of the 3^{rd} column, the 7^{th} column, the 11^{th} column, and the 15^{th} column of ferroelectric memory cells 10 respectively, the four multiplexers 20 send the four read signals to the four sense amplifiers SA, and the four sense amplifiers SA may respectively compare the four read signals with the reference voltage Vref, to determine that the four read signals are 1 or 0. Then, after receiving the read signals of the 4^{th} column, the 8^{th} column, the 12^{th} column, and the 16^{th} column of ferroelectric memory cells 10 respectively, the four multiplexers 20 send the read signals to the four sense amplifiers SA, and the four sense amplifiers SA may respectively compare the four read signals with the reference voltage Vref, to determine that the four read signals are 1 or 0.

In addition, the foregoing example is described by using an example in which the (m*n+1)^{th} column, the (m*n+2)^{th} column, the (m*n+3)^{th} column, and the (m*n+4)^{th} column of ferroelectric memory cells 10 are sequentially read. In some other possible implementations, a read sequence of the (m*n+1)^{th} column, the (m*n+2)^{th} column, the (m*n+3)^{th} column, and the (m*n+4)^{th} column may be alternatively changed. Principles of a read process and a determining process after change are the same as those in the foregoing example, and details are not described herein again.

For driving the ith plate line to work, the drive circuit may be used to send a high level or a low level to the ith plate line through the ith plate line selector. For a specific connection manner and a driving process, refer to the foregoing embodiments. Details are not described herein again.

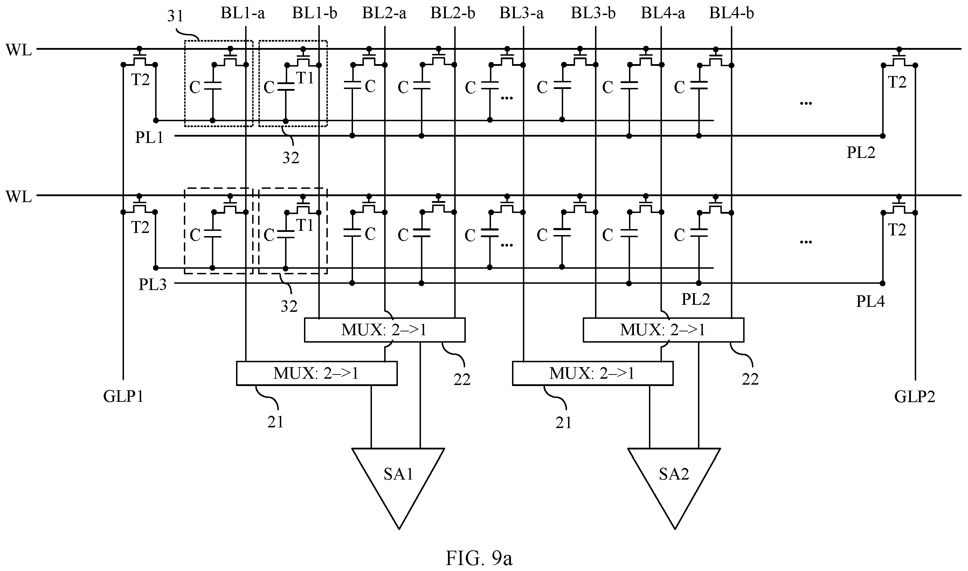

The foregoing embodiment illustrates a working principle of the 1T1C ferroelectric memory cell 10. In another embodiment, the ferroelectric memory cell 10 may alternatively be a 2T2C memory cell. As shown in FIG. 9a, the ferroelectric random access memory includes a plurality of bit lines, an ith plate line, a first multiplexer 21, a second multiplexer 22, a sense amplifier SA, and a plurality of ferroelectric memory cells 10. The plurality of ferroelectric memory cells 10 are grouped into at least one ferroelectric memory array 101. Each ferroelectric memory array 101 includes a plurality of ferroelectric memory cells 10 arranged in array. The ferroelectric memory cell 10 includes a first ferroelectric memory cell 31 and a second ferroelectric memory cell 32. Each of the first ferroelectric memory cell 31 and the second ferroelectric memory cell 32 includes one ferroelectric capacitor C and one first transistor T1. In any row of the ferroelectric memory array 101, a ferroelectric capacitor C of the (m*n+i)^{th} column of ferroelectric memory cells 10 is electrically connected to the ith plate line. In a read phase, each plate line in the ith plate line inputs a high level to the ferroelectric memory cell 10 in a time division manner, where m is an integer greater than or equal to 2, n is an integer greater than or equal to 0, and i is a positive integer less than or equal to m.

In the plurality of ferroelectric memory cells 10, each column of first ferroelectric memory cells 31 are electrically connected to one of the bit lines and each column of second ferroelectric memory cells 32 are electrically connected to one of the bit lines, m bit lines electrically connected to every m adjacent columns of first ferroelectric memory cells 31 are electrically connected to the first multiplexer 21, m bit lines electrically connected to every m adjacent columns of second ferroelectric memory cells 32 are electrically connected to the second multiplexer 22, and output ends of a first multiplexer 21 and a second multiplexer 22 that are electrically connected to a first ferroelectric memory cell 31 and a second ferroelectric memory cell 32 of a ferroelectric memory cell 10 are electrically connected to input ends of a same sense amplifier SA.

Ferroelectric memory cells 10 in a ferroelectric memory array 101 are arranged in array. In this case, the ferroelectric memory array 101 includes at least two adjacent columns of ferroelectric memory cells 10, that is, m is an integer greater than or equal to 2.

In some possible implementations, a quantity m of columns and a quantity of rows of ferroelectric memory cells 10 in the ferroelectric memory array 101 are not limited in embodiments of this application.

Optionally, the quantity m of columns of ferroelectric memory cells 10 in the ferroelectric memory array 101 may be determined based on a size of the sense amplifier SA, so that m consecutive adjacent columns of ferroelectric memory cells 10 may be disposed opposite to the sense amplifier SA. In this way, a bit line BL electrically connected to a part of ferroelectric memory cells 10 can be electrically connected to the multiplexer 20 without a need to extend in a row direction, to avoid affecting strength of a read signal due to a great increase in a capacitance value of a bit line capacitance C_{BL} caused by lengthening of the bit line BL. For example, m may be equal to 2 or 4. Certainly, when the size of the sense amplifier SA is large enough, and the m consecutive adjacent columns of ferroelectric memory cells 10 may be disposed opposite to the sense amplifier SA, m may alternatively be another value. This is not limited in embodiments of this application.

Optionally, the quantity of rows of ferroelectric memory cells 10 in the ferroelectric memory array 101 may be equal to a total quantity of rows of the ferroelectric memory cells 10 in the ferroelectric random access memory.

A person skilled in the art needs to know that, when a ferroelectric memory array 101 includes a plurality of rows of ferroelectric memory cells 10, the plurality of rows of ferroelectric memory cells 10 in the ferroelectric memory array 101 need to read signals row by row in a time division manner.

In some possible implementations, a value of n is not limited in embodiments of this application. The value of n is related to a total quantity of the plurality of ferroelectric memory cells 10 in the ferroelectric random access memory and a quantity of ferroelectric memory cells 10 in a ferroelectric memory array 101. For example, n may be 0, 1, 2, or 3.

The following uses m=2 as an example to describe a working process of the ferroelectric random access memory in the read phase in embodiments of this application.

As shown in FIG. 9a, for example, m=2, the ferroelectric random access memory includes four columns of ferroelectric memory cells 10, and the four columns of ferroelectric memory cells 10 are grouped into two ferroelectric memory arrays 101. Each ferroelectric memory array 101 includes two columns of ferroelectric memory cells 10, and each ferroelectric memory cell 10 includes one first ferroelectric memory cell 31 and one second ferroelectric memory cell 32. The first ferroelectric memory cell 31 and the second ferroelectric memory cell 32 each include one first transistor T1 and one ferroelectric capacitor C. The ferroelectric random access memory may further include a plurality of word lines WL, a first electrode 11 of the ferroelectric capacitor C is electrically connected to a first electrode of the first transistor T1, and a second electrode 12 of the ferroelectric capacitor C is electrically connected to the ith plate line. A gate of the first transistor T1 is electrically connected to a word line WL, the first electrode of the first transistor T1 is electrically connected to the ith plate line through the ferroelectric capacitor C, and a second electrode of the first transistor T1 is electrically connected to a bit line BL.

In any row of the ferroelectric random access memory, a ferroelectric capacitor C of an odd column of ferroelectric memory cells 10 is electrically connected to a first plate line PL1 in the ith plate line, and a ferroelectric capacitor C of an even column of ferroelectric memory cells 10 is electrically connected to a second plate line PL2 in the ith plate line. In the ferroelectric random access memory, first transistors T1 of each column of first ferroelectric memory cells 31 may be electrically connected to one of the bit lines BL and first transistors T1 of each column of second ferroelectric memory cells 32 may be electrically connected to one of the bit lines BL. For example, the 1^{st} column of first ferroelectric memory cells 31 is electrically connected to a bit line BL1-a, the 1^{st} column of second ferroelectric memory cells 32 is electrically connected to a bit line BL1-b, the 2^{nd} column of first ferroelectric memory cells 31 is electrically connected to a bit line BL2-a, the 2^{nd} column of second ferroelectric memory cells 32 is electrically connected to a bit line BL2-b, and so on.

Based on a circuit structure of the ferroelectric random access memory, for any row of the ferroelectric random access memory, in the read phase, the first plate line PL1 and the second plate line PL2 may be first controlled to input a high level to four columns of ferroelectric memory cells 10 in a time division manner, to read signals.

To be specific, the first plate line PL1 first inputs a high level to two odd columns of ferroelectric memory cells 10, and bit lines electrically connected to two odd columns of ferroelectric memory cells 10 input a low level to the two odd columns of ferroelectric memory cells 10. Then, the low level is cut off, so that the bit lines electrically connected to the two odd columns of ferroelectric memory cells 10 are in a floating state, read signals of the two odd columns of first ferroelectric memory cells 31 are sent to two first multiplexers 21 respectively through the bit lines, and read signals of the two odd columns of second ferroelectric memory cells 32 are sent to two second multiplexers 22 respectively through the bit lines.

Then, the second plate line PL2 inputs a high level to two even columns of ferroelectric memory cells 10, and bit lines electrically connected to the two even columns of ferroelectric memory cells 10 input a low level to the two even columns of ferroelectric memory cells 10. Then, the low level is cut off, so that the bit lines electrically connected to the two even columns of ferroelectric memory cells 10 are in a floating state, read signals of the two even columns of first ferroelectric memory cells 31 are sent to the two first multiplexers 21 respectively through the bit lines, and read signals of the two even columns of second ferroelectric memory cells 32 are sent to the two second multiplexers 22 respectively through the bit lines.

Although two columns of first ferroelectric memory cells 31 in a ferroelectric memory array 101 may send read signals to a same first multiplexer 21, and two columns of second ferroelectric memory cells 32 in the ferroelectric memory array 101 may send read signals to a same second multiplexer 22, because two adjacent columns of ferroelectric memory cells 10 in the ferroelectric memory array 101 read read signals in a time division manner, there is no case in which a plurality of ferroelectric memory cells 10 simultaneously send the read signals to the same first multiplexer 21 or the same second multiplexer 22 through a plurality of bit lines, and the plurality of bit lines do not need to sequentially transmit the read signals to the first multiplexer 21 or the same second multiplexer 22. This can avoid a case in which the read signals finally received by the sense amplifier SA become weak due to losses of the read signals in a process of waiting to be transmitted to the first multiplexer 21 or the same second multiplexer 22, and can further shorten total time of the read phase, to improve read efficiency.

In addition, there is always an even column of ferroelectric memory cells 10 spaced between every two adjacent odd columns of ferroelectric memory cells 10; and there is always an odd column of ferroelectric memory cells 10 spaced between every two adjacent even columns of ferroelectric memory cells 10. This can avoid affecting strength of the read signals due to a problem of mutual coupling between the signals on the bit lines that are electrically connected to the two adjacent columns of ferroelectric memory cells 10 in the read phase. On this basis, in a phase of reading the odd column, a low level may be further provided for the bit line electrically connected to the even column of ferroelectric memory cells 10, so that the bit line electrically connected to the even column of ferroelectric memory cells 10 is in a shielded state, to shield coupling between both sides of the odd column and the bit line electrically connected to the odd column of ferroelectric memory cells 10, so as to further resolve the foregoing coupling problem. Similarly, in a phase of reading the even column, a low level may be further provided for the bit line electrically connected to the odd column of ferroelectric memory cells 10.

In addition, because the problem of mutual coupling between the signals on the bit lines that are electrically connected to the two adjacent columns of ferroelectric memory cells 10 in the read phase is resolved, there is no need to use a large-area ferroelectric capacitor C to reduce read signal interference caused by coupling, so that a layout area of the ferroelectric capacitor C and even a layout area of the ferroelectric random access memory can be reduced.

Based on the foregoing descriptions, after receiving the read signals of the two columns of the first ferroelectric memory cells 31 and the read signals of the two columns of the second ferroelectric memory cells 32 respectively, the two first multiplexers 21 and the two second multiplexers 22 send the four read signals to two sense amplifiers SA. After a read signal of the 1^{st} column of the first ferroelectric memory cells 31 passes through the first multiplexer 21, and a read signal of the 1^{st} column of the second ferromagnetic memory cell 32 passes through the second multiplexer 22, both the two read signals are sent to a sense amplifier SA1. The sense amplifier SA1 may compare the read signal of the 1^{st} column of the first ferroelectric memory cells 31 with the read signal of in the 1^{st} column of the second ferroelectric memory cells 32, to determine that the read signal of the 1^{st} column of the first ferroelectric memory cells 31 is 1, and the read signal of the 1^{st} column of the second ferroelectric memory cells 32 is 0; or determine that the read signal of the 1^{st} column of the first ferroelectric memory cells 31 is 0, and the read signal of the 1^{st} column of the second ferroelectric memory cells 32 is 1.

Similarly, processes of determining the read signals of the 2^{nd} column to the 4^{th} column of ferroelectric memory cells 10 are the same as processes of determining the read signal of the 1^{st} column of ferroelectric memory cells 10. Details are not described herein again.

In addition, the foregoing example is described by using an example in which the read signals of the odd columns of ferroelectric memory cells 10 are first read, and then the read signals of the even columns of ferroelectric memory cells 10 are read. In some other possible implementations, the read signals of the even columns of ferroelectric memory cells 10 may be read first, and then the read signals of the odd columns of ferroelectric memory cells 10 may be read. Principles of a read process and a determining process in the read manner are the same as those in the foregoing example, and details are not described herein again.

In addition, in some embodiments, the ferroelectric random access memory may further include a drive circuit and an ith plate line selector, and the drive circuit may send a high level or a low level to the ith plate line through the ith plate line selector.

Specifically, the ith plate line selector is electrically connected to the ith plate line, and is configured to send the high level to the ith plate line in the read phase. The ith plate line selector includes a second transistor T2, and a gate of the second transistor T2 in the ith plate line selector may be electrically connected to a word line WL electrically connected to the ith plate line. In this way, a first transistor T1 of in the i^{th} column of ferroelectric memory cells 10 and the second transistor T2 electrically connected to the ith plate line may be simultaneously turned on. When a read signal of the (m*n+i)^{th} column of ferroelectric memory cells 10 is read, a source of the second transistor T2 in the ith plate line selector inputs a high level to the ith plate line, and a voltage received by a source of another second transistor T2 is 0 V Therefore, in a phase of reading the (m*n+i)^{th} column of ferroelectric memory cells 10, only the second transistor T2 of the ith plate line selector inputs the high level to the (m*n+i)^{th} column of ferroelectric memory cells 10 through the ith plate line, to read the read signal.

For example, in a phase of reading the (m*n+1)^{th} column of ferroelectric memory cells 10, only a second transistor T2 of a first plate line selector inputs a high level to the (m*n+1)^{th} column of ferroelectric memory cells 10 through the first plate line, to read the read signal. A second transistor T2 of another plate line selector inputs 0 V to a ferroelectric memory cell 10 other than the (m*n+1)^{th} column of ferroelectric memory cells 10 through another plate line. In this way, the ferroelectric memory cell 10 other than the (m*n+1)^{th} column of ferroelectric memory cells 10 has no signal to be read presently.

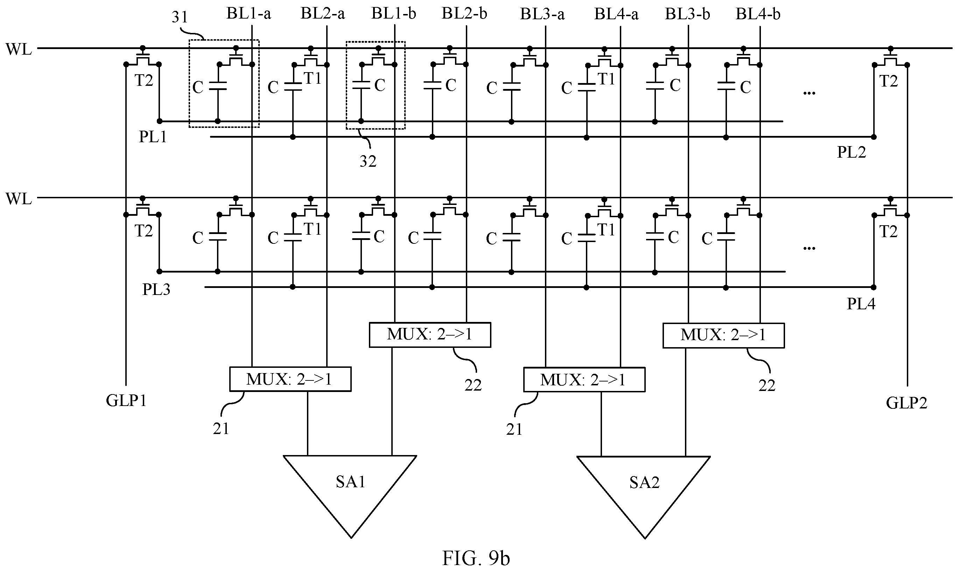

The foregoing example shows a case in which the first ferroelectric memory cell 31 and the second ferroelectric memory cell 32 are adjacently disposed in a 2T2C ferroelectric memory cell 10. In some other possible implementations, the first ferroelectric memory cell 31 and the second ferroelectric memory cell 32 of one ferroelectric memory cell 10 may alternatively be spaced from each other. For example, as shown in FIG. 9b, in every two adjacent columns of ferroelectric memory cells 10, a second ferroelectric memory cell 32 of the 1^{st} ferroelectric memory cell 10 is disposed between a first ferroelectric memory cell 31 and a second ferroelectric memory cell 32 that are of the 2^{nd} ferroelectric memory cell 10.

In this case, two columns of first ferroelectric memory cells 31 in every two adjacent columns of ferroelectric memory cells 10 are still electrically connected to a first multiplexer 21, and two columns of second ferroelectric memory cells 32 in every two adjacent columns of ferroelectric memory cells 10 are still electrically connected to a second multiplexer 22. One first multiplexer 21 and one second multiplexer 22 that are electrically connected to every two adjacent columns of ferroelectric memory cells 10 are still electrically connected to a same sense amplifier SA.

As shown in FIG. 9a and FIG. 9b, for a solution shown in FIG. 9a, in the read phase, if the odd column of ferroelectric memory cells 10 works, two read signals transmitted by the bit line BL1-a and the bit line BL1-b are 0 and 1 respectively. In addition, because the bit line BL1-a and the bit line BL1-b are disposed adjacently, a read signal on the bit line BL1-a and a read signal on the bit line BL1-b may interfere with each other.

However, for a solution in FIG. 9b, in the read phase, although the ferroelectric memory cell 10 electrically connected to the bit line BL1-a and the bit line BL1-b also works, because the bit line BL2-a is further spaced between the bit line BL1-a and the bit line BL1-b, mutual interference between the read signal on the bit line BL1-a and the read signal on the bit line BL1-b can be reduced.

On this basis, in the read phase, when the ferroelectric memory cell 10 electrically connected to the bit line BL1-a and the bit line BL1-b works, a low level may be further provided for the bit line BL2-a and the bit line BL2-b, so that the bit line BL2-a and the bit line BL2-b are in a shielded state, to shield coupling between both sides of the bit line BL1-a or the bit line BL1-b and the bit line BL1-a or the bit line BL1-b, so as to further resolve the foregoing coupling problem.

The foregoing example describes, by using an example, a scenario in which the ferroelectric memory cell 10 electrically connected to the bit line BL1-a and the bit line BL1-b works. In some other possible implementations, when the ferroelectric memory cell 10 electrically connected to the bit line BL2-a and the bit line BL2-b works, a low level may also be provided for the bit line BL1-a and the bit line BL1-b, to implement the foregoing shielding function.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A ferroelectric random access memory, comprising a plurality of bit lines, an ith plate line, a multiplexer, a sense amplifier, and a plurality of ferroelectric memory cells, wherein the plurality of ferroelectric memory cells are grouped into at least one ferroelectric memory array, each of the ferroelectric memory array comprises m columns of ferroelectric memory cells arranged in array, and the ferroelectric memory cell comprises one ferroelectric capacitor and one first transistor;
in any row of the ferroelectric memory array, a ferroelectric capacitor of the (m*n+i)^{th} column of the ferroelectric memory cells is electrically connected to the ith plate line; and in a read phase, each plate line in the ith plate line inputs a high level to the ferroelectric memory cell in a time division manner, wherein m is an integer greater than or equal to 2, n is an integer greater than or equal to 0, and i is a positive integer less than or equal to m; and
in the plurality of ferroelectric memory cells, first transistors of each column of the ferroelectric memory cells are electrically connected to one of the bit lines, m bit lines electrically connected to one of the ferroelectric memory array are electrically connected to asame multiplexer, and an input end of each sense amplifier is electrically connected to an output end ofone multiplexer.

2. The ferroelectric random access memory according to claim 1, wherein m=2;
in any row, a ferroelectric capacitor of an odd column of the ferroelectric memory cells is electrically connected to a first plate line in the ith plate line, and a ferroelectric capacitor of an even column of the ferroelectric memory cells is electrically connected to a second plate line in the ith plate line; and
two of the bit lines electrically connected to every two adjacent columns of the ferroelectric memory cells are electrically connected to a same multiplexer.

3. The ferroelectric random access memory according to claim 1, wherein m=4;
in any row, a ferroelectric capacitor of the (m*n+1)^{th} column of the ferroelectric memory cells is electrically connected to a first plate line in the ith plate line, a ferroelectric capacitor of the (m*n+2)^{th} column of the ferroelectric memory cells is electrically connected to a second plate line in the ith plate line, a ferroelectric capacitor of the (m*n+3)^{th} column of the ferroelectric memory cells is electrically connected to a third plate line in the ith plate line, and a ferroelectric capacitor of the (m*n+4)^{th} column of the ferroelectric memory cells is electrically connected to a fourth plate line in the ith plate line; and
four bit lines electrically connected to every four adjacent columns of the ferroelectric memory cells are electrically connected to a same multiplexer.

4. The ferroelectric random access memory according to any one of claims 1 to 3, wherein the ferroelectric random access memory further comprises a plurality of word lines; and
in the plurality of ferroelectric memory cells, gates of first transistors in one row of the ferroelectric memory cells are electrically connected to a same word line in a row direction.

5. The ferroelectric random access memory according to claim 4, wherein the ferroelectric random access memory further comprises an ith plate line selector; and
the ith plate line selector is electrically connected to the ith plate line, and is configured to send the high level to the ith plate line in the read phase.

6. The ferroelectric random access memory according to claim 5, wherein the ith plate line selector comprises a second transistor, and both the first transistor and the second transistor are N-type transistors or P-type transistors;
a gate of the second transistor in the ith plate line selector is electrically connected to the word line electrically connected to the ith plate line; and
when a read signal of the (m*n+i)^{th} column of the ferroelectric memory cells is read, a source of the second transistor in the ith plate line selector inputs the high level to the ith plate line, and a voltage received by a source of another second transistor is 0 V.

7. A ferroelectric random access memory, comprising a plurality of bit lines, an ith plate line, a first multiplexer, a second multiplexer, a sense amplifier, and a plurality of ferroelectric memory cells, wherein the plurality of ferroelectric memory cells are grouped into at least one ferroelectric memory array, each of the ferroelectric memory array comprises m columns of ferroelectric memory cells arranged in array, the ferroelectric memory cell comprises a first ferroelectric memory cell and a second ferroelectric memory cell, and each of the first ferroelectric memory cell and the second ferroelectric memory cell comprises one ferroelectric capacitor and one first transistor;
in any row of the ferroelectric memory array, a ferroelectric capacitor of the (m*n+i)^{th} column of the ferroelectric memory cells is electrically connected to the ith plate line; and in a read phase, each plate line in the ith plate line inputs a high level to the ferroelectric memory cell in a time division manner, wherein m is an integer greater than or equal to 2, n is an integer greater than or equal to 0, and i is a positive integer less than or equal to m; and
in the plurality of ferroelectric memory cells, each column of the first ferroelectric memory cell are electrically connected to one of the bit lines and each column of the second ferroelectric memory cell are electrically connected to one of the bit lines, m bit lines electrically connected to every m adjacent columns of the first ferroelectric memory cells are electrically connected to the first multiplexer, m bit lines electrically connected to every m adjacent columns of the second ferroelectric memory cells are electrically connected to the second multiplexer, and output ends of a first multiplexer and a second multiplexer that are electrically connected to a first ferroelectric memory cell and a second ferroelectric memory cell of a ferroelectric memory cell are electrically connected to input ends of a same sense amplifier.

8. The ferroelectric random access memory according to claim 7, wherein m=2;
in any row, a ferroelectric capacitor of an odd column of the ferroelectric memory cells is electrically connected to a first plate line in the ith plate line, and a ferroelectric capacitor of an even column of the ferroelectric memory cells is electrically connected to a second plate line in the ith plate line; and
two of the bit lines electrically connected to every two adjacent columns of the first ferroelectric memory cells are electrically connected to the first multiplexer, and two of the bit lines electrically connected to every two adjacent columns of the second ferroelectric memory cells are electrically connected to the second multiplexer.

9. The ferroelectric random access memory according to claim 7 or 8, wherein the ferroelectric random access memory further comprises a plurality of word lines; and
in the plurality of ferroelectric memory cells, gates of first transistors in one row of the ferroelectric memory cells are electrically connected to a same word line in a row direction.

10. The ferroelectric random access memory according to claim 9, wherein the ferroelectric random access memory further comprises an ith plate line selector; and
the ith plate line selector is electrically connected to the ith plate line, and is configured to send the high level to the ith plate line in the read phase.

11. The ferroelectric random access memory according to claim 10, wherein the ith plate line selector comprises a second transistor, and both the first transistor and the second transistor are N-type transistors or P-type transistors;
a gate of the second transistor in the ith plate line selector is electrically connected to the word line electrically connected to the ith plate line; and
when data of the (m*n+i)^{th} column of the ferroelectric memory cells is read, a source of the second transistor in the ith plate line selector inputs the high level to the ith plate line, and a voltage received by a source of another second transistor is 0 V

12. A terminal, comprising a circuit plate line and the ferroelectric random access memory according to any one of claims 1 to 6 or any one of claims 7 to 11, wherein the ferroelectric random access memory is disposed on the circuit board.
